# EUROPEAN PATENT SPECIFICATION

(11) **EP 3 106 705 B1**
(45) Date of publication and mention of the grant of the patent: **06.02.2019**
(21) Application number: 16174592.2
(22) Date of filing: 15.06.2016
(51) Int. Cl.: F16F 1/387, G06F 17/50

(54) **STRENGTHING METHOD FOR RUBBER KNOT**
STÄRKUNGSVERFAHREN FÜR GUMMIKNOTEN
PROCÉDÉ DE RENFORCEMENT POUR NOEUD DE CAOUTCHOUC

(30) Priority: 18.06.2015 CN 201510339748; 18.06.2015 CN 201520422606 U
(43) Date of publication of application: 21.12.2016
(73) Proprietor: Zhuzhou Times New Material Technology Co., Ltd., Zhuzhou, Hunan 412007 (CN)
(72) Inventor: FENG, Wansheng, Zhuzhou Hunan (CN); CHENG, Haitao, Zhuzhou City, Hunan province (CN); RONG, Jigang, Zhuzhou Hunan (CN); LIN, Sheng, Zhuzhou Hunan (CN); ZHANG, Yuxiang, Zhuzhou Hunan (CN); JIANG, Zhongsan, Zhuzhou Hunan (CN); LUO, Jun, Zhuzhou Hunan (CN); ZENG, Hui, Zhuzhou Hunan (CN)
(74) Representative: Keil & Schaafhausen Patent- und Rechtsanwälte PartGmbB

(56) References cited:
- CN-A- 104 074 901
- US-A- 4 575 358

## Description

### Technical Field:

The current invention relates to a reinforcement method for a rubber node and is especially related to a reinforcement method for the integral empty and real direction rubber node and the integral empty and real rubber node.

### Technical Background:

Rubber nodes are used in the suspension system of vehicle bogies. They are one of the key elements that realize stable vehicle traction and braking and guarantee the comfort of the vehicle dynamics. In railway vehicles, rubber nodes are installed on the two ends of the traction rod as flexible connection joints. One end of the traction rod is connected with the vehicle bogie via the rubber node, whereas the other end is connected to the vehicle body via the rubber node, in order to transmit the traction force and the braking force between the bogie and the vehicle body, so that the railway vehicles have good dynamic comfort during traction, braking and operation. The technical solutions of rubber nodes can be divided into three categories according to their structures: integral revolution rubber nodes, integral empty and real rubber nodes and compositional resolution rubber nodes.

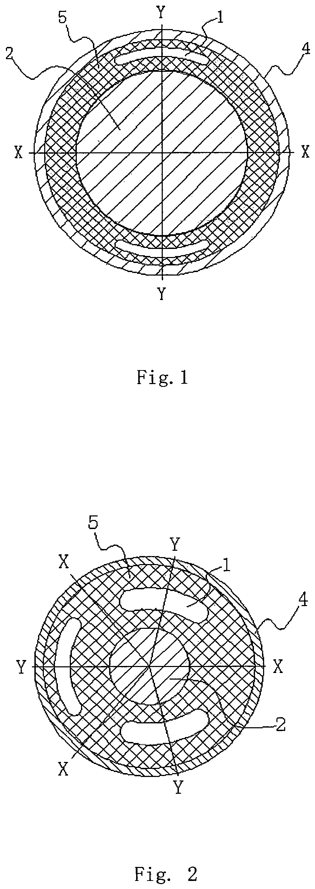

The current integral empty and real rubber node structurally contains a metal dabber (or a metal case), metal coat and rubber elastic body with interspaces, wherein these three parts are integrated through sulfuration and processed into the product through radical compression and secondary processing. In the rubber node, the direction which extends from its middle point to the interspace containing rubber elastic body is called empty direction, whereas the direction which extends from its middle pint to the rubber elastic body without interspace is called real direction. Fig. 1 shows an integral empty and real rubber node with two interspaces 1, wherein the two interspaces 1 are distributed symmetrically about the axis of the metal dabber 2. In this figure, X direction represents the real direction of the rubber node, and Y represents the empty direction of the rubber node. It can be seen from Fig.1 that empty and real directions are distributed sequentially circumferentially in the rubber node.

During the processing procedure, after the rubber node has been compressed, the metal coat of the rubber node is deformed into an oval, which affects the installation of the rubber node. This phenomenon is called product oval phenomenon. In addition, due to the loading during the application, the product oval phenomenon can be increased with the increase of usage time. As a result, the property as well as the life of the product will be affected on the one hand, and the other related components will also be damaged on the other hand.

CN 101520076A, with the publication date of Sept,2, 2009, disclosed a rigidity variation method of elastic components including coat, inner case and elastic rubber body. The method comprises emptying the elastic rubber body in the operation direction of the elastic component to form an air isolation region and an air section exists in this direction and a discontinuous structure is formed. Different radical rigidity of products of different stages is formed through different parts of the elastic component. In this way, it can be realized that the elastic component have different rigidity changes under different circumstances.

The elastic component described in the patent application document above has empty and real directions. After it is compressed radically, the degree of deformation in the empty and real directions of the metal coat, which causes the above mentioned problems.

The US patent, US 4,575,358, discloses a constant velocity joint comprising an inner shall having an exterior surface defined by an axis, an outer shell disposed about the inner shell and having an interior surface defined by the axis, and a plurality of elastomer layers having interposed shims.

The Chinese patent application, CN 104074901 A, discloses a nonlinear stiffness eased-transition traction node and a nonlinear stiffness control method thereof. The nonlinear stiffness eased-transition traction node comprises a metal core shaft, a metal outer sleeve and a rubber elastomer. The metal core shaft comprises a shaft body and a flange. The flange of the metal core shaft is a prism with one bottom surface which is a parallelogram. Four corner angles of the parallelogram prism are in a state that the four corner angles are mutually perpendicular pairwise. The two pairs of corner angles are located in the virtual direction and the real direction respectively. The opposite corner angles of the parallelogram prism along the virtual direction and the real direction are arranged into circular corner angles. Virtual direction grooves which are symmetrical relative to the axis of the metal outer sleeve are formed in the inner wall of the metal outer sleeve along the virtual direction. Each virtual direction groove comprises an arc-shaped virtual direction groove bottom edge and virtual direction groove straight edges which are formed on the bilateral sides respectively. The nonlinear stiffness eased-transition traction node is obvious in radial stiffness nonlinearity characteristic and nonlinear stiffness eased transition characteristic and accordingly the problem that the traction node is oval is solved. The high running speed and the good riding com-fort of rail vehicles can be further ensured by the nonlinear stiffness control method.

Fig. 2 discloses an integral empty and real rubber node provided with three interspaces, wherein the two interspaces 1 are distributed symmetrically about the axis of the metal dabber 2. In this figure, X direction represents the real direction of the rubber node, and Y represents the empty direction of the rubber node. It can be seen from Fig. 2 that empty and real directions are also distributed sequentially circumferentially in the rubber node.

After the integral empty and real rubber node in Fig. 2 has been compressed, it can also occur that the difference of the degree of deformation of the metal coat of the rubber node is large, which affects the installation of the rubber node, the characteristics and shelf life of the product, as well as the relevant components.

### Technical problem:

Based on the above, the technical problem which urgently needs to be resolved is to provide a design which can reduce the difference of the degree of deformation of the metal coat in the empty and the real directions, in order to facilitate its installation, enhance the property and prolong the shelf life of the rubber node as well as to avoid the damage of other related components.

### Technical solution:

The invention is defined by the appended claims. The technical problem of the current invention is to provide a design which can reduce the difference of the degree of deformation of the metal coat in the empty and the real directions, in order to facilitate its installation, enhance the property and prolong the shelf life of the rubber node as well as to avoid the damage of other related components.

To overcome this technical problem, the current invention provides the following technical solution: A reinforcement method for an integral empty and real direction rubber node, characterized in that the reinforcement method is carried out through providing the inner wall of the metal coat in the stress transition zone of the integral empty and real rubber node with a reinforcement structure lug in order to strengthen the metal coat.

Preferably, the exact position of the reinforcement structure lug in the stress transition zone is determined by the distribution of the rigidity, applied force and stress of the integral empty and real rubber node after it is radically compressed, comprising the following steps:
(1) determination of the concrete structure of the integral empty and real rubber node according to the design of the rigidity of the integral empty and real rubber node;
(2) calculation of the distribution of the applied force and the stress after radical compression of the integral empty and real rubber node in step (1) according to finite element method;
(3) determination of the position of the stress transition zone according to the result in step (2), and positioning of the reinforcement structure lug onto the inner wall of the metal coat in the stress transition zone to obtain the integral empty and real rubber node with a reinforcement structure lug;
(4) calculation of the distribution of the rigidity, applied force after compression and stress of the integral empty and real rubber node with a reinforcement structure through finite element method;
(5) examining whether the distribution of the rigidity, applied force after compression and stress calculated in step (4) fulfills requirement; if yes, then the entire reinforcement procedure is completed; if there is one item being not in compliance with the requirement, adjusting the position of the reinforcement structure lug on the inner wall of the metal coat in the stress transition zone peripherally, and returning to step (4) until completing the entire reinforcement procedure.

Preferably, the finite element calculation method in step (2) is to establish a model through 3D software, and to determine the material nature of different components of the integral empty and real rubber node and then calculate to obtain the stress and strain contours of the metal coat as well as the metal dabber, and to determine the deformation state of the metal coat as well as the metal dabber of the integral empty and real rubber node under specified condition, comprising the following steps:
a. using software to establish a geometric feature model of the integral empty and real rubber node and determining geometric characteristics of the different components of the integral empty and real rubber node in the software;
b. converting the geometric feature model of the integral empty and real rubber node into a format which is supported by meshing softwares, and simplifying the details which do not influence the analysis, and finally meshing to all of the components and establishing an integral empty and real rubber node meshing model;
c. performing relationship definition to the corresponding surfaces of all the components of the integral empty and real rubber node , and performing surface connection of all the components according to the relationship definition;
d. performing material and attribute definition of all the components of the integral empty and real rubber node;
e. exerting corresponding peripheral condition and loading condition in the meshing model of the integral empty and real rubber node according to the real loading and peripheral condition of the integral empty and real rubber node;
f. submitting the established model to the finite element analysis software for calculation to obtain stress and strain distribution of all the components and finally the stress and strain contours of the metal coat and metal dabber, and determining the deformation state of the metal coat and metal dabber of the integral empty and real rubber node in specified conditions.

Preferably, a nodal method is used in the surface connection in step c is to perform common nodal treatment for all the component surfaces.

Preferably, the material and attribute definition in step d is determined by the real loading condition, namely, when the real loading is relatively small, the deformation of the integral empty and real rubber node is relatively small, the metal coat and the metal dabber need only to be defined to be elastic attribute and little deformed constitutive model is chosen for the rubber elastic body; when the real loading is relatively large, the deformation of the integral empty and real rubber node is relatively large, the metal coat and the metal dabber need to be defined as plastic attribute and large deformed or non-linear constitutive model is chosen for the rubber elastic body.

An integral empty and real pulling node in the above mentioned reinforcement method, comprises a metal dabber, a metal coat and a rubber elastic body with interspaces, wherein the metal dabber comprises a metal axis body and a metal dabber flange in the middle of the metal axis body, and the rubber elastic body is located between the flange of the metal axis body and the metal coat, and the rubber elastic body, the flange of the metal axis body and the metal coat are integrated through sulfuration, characterized in that the inner wall of the metal coat is provided with a reinforcement structure lug which protrudes towards the flange of the metal axis body, wherein the reinforcement structure lug is located at the connecting point of the empty and the real directions of the integral empty and real pulling node.

Preferably, the reinforcement structure lug assumes a triangle, a trapezoid or an arc form.

Preferably, the two said interspaces are provided, and their axes about the metal dabber are symmetrically distributed on the rubber elastic body; the inner wall of the metal coat is provided with two grooves along the real direction, wherein the two grooves are symmetric about the metal dabber, and the inner wall of the metal coat is also provided with two grooves along the empty direction, wherein the two grooves are symmetric about the metal dabber, so that the protruding reinforcement lug is formed on the inner all of the metal coat and between the neighbouring real direction groove and empty direction groove.

Preferably, when the reinforcement structure lug has a triangle form, said empty direction grove comprises arc shaped empty direction bottom line and direct lines which are located along the two sides of the arc shaped empty direction groove, said real direction groove comprises arc shaped real direction bottom line and direct lines which are located along the two sides of the arc shaped real direction groove; wherein the metal dabberflange is designed to be a prism with a parallelogram bottom, wherein the four corners are vertical to each other, with one pair opposite corners being located at the empty direction and the other pair opposite corners being located at the real direction, wherein the opposite corner pair along the empty direction of the parallelogram prism are round corners, and the other opposite corner pair along the real direction of the parallelogram prism are also round corners.

Preferably, three said interspaces are provided which are circumferentially sequentially distributed on the rubber elastic body, wherein two interspaces are distributed symmetrically about the axis of the metal dabber; and wherein the inner wall of the metal coat along the empty direction is provided with three empty direction grooves, which are circumferentially sequentially distributed on the inner wall of the metal coat, so that the reinforcement structure lug is formed on the inner wall of the metal coat between the neighbouring empty direction grooves.

The advantages of the current invention lie in:
1) The current invention reinforces the metal coat through providing the inner wall of the metal coat in the stress transition zone of the integral empty and real rubber node with a reinforcement structure lug, which significantly reduces the difference of the degree of deformation of the metal coat in the empty and the real directions, and reduces the occurrence of product oval phenomenon, and facilitates the installation of the integral empty and real rubber node, enhances the property and prolong the shelf life of the rubber node as well as avoids the damage of other related components.
2) The current invention localizes the exact position of the reinforcement structure lug in appropriate position of the stress transition zone, which promotes the reinforcement effect. A more accurate stress and strain contour can be obtained through the finite element method of the current invention, which provides a more accurate scientific base for providing the reinforcement structure lug.
3) During the establishment the model using the 3D software, a radical preloading is added in the model, so that a real simulation of the real product environment can be achieved, which facilitates a more accurate calculation.
4) The reinforcement structure lug is designed to be triangle, trapezoid, or oval, which can increases the area of the reinforcement structure lug, in order to further reduce the difference of the degree of deformation of the metal coat in the empty and the real directions, and to avoid stress centralization caused by angle position.
5) The further improvement of the flange of the metal dabber enables the change of the rigidity of the integral empty and real rubber node to be smoothly realized in three stages. As a result, the integral empty and real rubber node of the current invention has not only the obvious non-linear rigidity characteristics, but also the smooth transition characteristics of the non-linear rigidity. This fulfills the requirement of locomotives to have a higher speed but more comfort at the same time.

### Figures:

Fig. 1 shows a radical cross section of an integral empty and real rubber node of the state of the art.
Fig. 2 shows a radical cross section of another integral empty and real rubber node of the state of the art.
Fig. 3 shows a radical cross section of the integral empty and real rubber node of example 1 of the current invention.
Fig.4 shows an axial cross section of the integral empty and real rubber node of example 1 obtained by the current invention.
Fig. 5 shows the structure of the metal coat of the integral empty and real rubber node of example 1 obtained by the current invention.
Fig. 6 shows a radical cross section of the integral empty and real rubber node of example 2 obtained by the current invention.
Fig. 7 is an enlarged view of a partial structure of Fig. 6
Fig. 8 shows a radical cross section of the integral empty and real rubber node of example 3 obtained by the current invention.

In these figures: 1. Interspace, 111. enlarged part of interspace. 2. Metal dabber, 211 axis body, 212 metal dabber flange, 3. Reinforcement structure lug, 4. Metal coat, 5. Rubber elastic body, 6. real direction groove, 611.arc shaped real direction groove bottom line, 612. Real direction groove direct line, 711. Arc shaped empty direction groove bottom line, 712, empty direction groove direct line.

### Embodiments:

After experiments and analysis, Applicant found that, due to the presence of interspaces, the rubber elastic body has discontinuity circumferentially. When the integral empty and real rubber node is compressed radically, this discontinuity renders relatively large bounce of the rubber elastic body in the real direction and relatively small bounce in the empty direction. This leads to a large difference in the degree of deformation in the empty and real direction of the metal coat of the product. Therefore, Applicant uses the reinforcement structure lug to reinforce the metal coat, in order to reduce the difference of degree of deformation of the metal coat in the empty and real directions. In addition, Applicant has realized after lots of calculation and analyses that, when the integral empty and real rubber node is compressed radically, this discontinuity leads to the appearance of stress transition zones of the metal coat position and the metal dabber position at the connecting positions between the empty and real directions (namely near the two ends of the interspaces). In this zone, the distribution of the stress is very uneven, which is an important factor that causes the different degree of deformation of the metal coat in the empty and real directions. The current invention uses the reinforcement structure lug in the stress transition zone to reinforce the metal coat, which significantly reduces the difference in the degree of deformation of the metal coat in the empty and real directions. What needs to be declared is that the empty and real directions are to be designed according to the real requirement. That is to say, the number and the positions of the interspaces are determined according to the requirement of real work. The current invention is further illustrated by rubber nodes with two interspaces (example 1 and 2) and a rubber node with three interspaces (example 3).

Example 1: A reinforcement method for an integral empty and real rubber node, characterized in that the reinforcement method is carried out through providing the inner wall of the metal coat in the stress transition zone of the integral empty and real rubber node with a reinforcement structure lug in order to reinforce the metal coat.

The exact position of the reinforcement structure lug in the stress transition zone is determined by the distribution of the rigidity, applied force and stress of the integral empty and real rubber node after it is radically compressed, comprising the following steps:
(1) determination of the concrete structure of the integral empty and real rubber node according to the design of the rigidity of the integral empty and real rubber node; namely to determine the number, size and distribution of the interspaces in the rubber elastic body;
(2) calculation of the distribution of the applied force and the stress after radical compression of the integral empty and real rubber node in step (1) according to finite element method;
(3) determination of the position of the stress transition zone according to the result in step (2), and positioning of the reinforcement structure lug onto the inner wall of the metal coat in the stress transition zone to obtain the integral empty and real rubber node with a reinforcement structure lug;
(4) calculation of the distribution of the rigidity, applied force after compression and stress of the integral empty and real rubber node with a reinforcement structure through finite element method;
(5) examining whether the distribution of the rigidity, applied force after compression and stress calculated in step (4) fulfills requirement; if yes, then the entire reinforcement procedure is completed; if there is one item being not in compliance with the requirement, adjusting the position of the reinforcement structure lug on the inner wall of the metal coat in the stress transition zone peripherally, and returning to step (4) until completing the entire reinforcement procedure.

Through the above method, the reinforcement structure lug can be exactly positioned onto the appropriate position, in order to promote the reinforcement effect.

The finite element calculation method is to establish a model through 3D software, and to determine the material nature of different components of the integral empty and real rubber node and then calculate to obtain the stress and strain contours of the metal coat as well as the metal dabber, and to determine the deformation state of the metal coat as well as the metal dabber of the integral empty and real rubber node under specified condition, comprising the following steps:
a. using software to establish a geometric feature model of the integral empty and real rubber node and determining geometric characteristics of the different components of the integral empty and real rubber node in the software;
b. converting the geometric feature model of the integral empty and real rubber node into a format which is supported by meshing softwares, and simplifying the details which do not influence the analysis, and finally meshing to all of the components and establishing an integral empty and real rubber node meshing model;
c. performing relationship definition to the corresponding surfaces of all the components of the integral empty and real rubber node , and performing surface connection of all the components according to the relationship definition;
d. performing material and attribute definition of all the components of the integral empty and real rubber node;
e. exerting corresponding peripheral condition and loading condition in the meshing model of the integral empty and real rubber node according to the real loading and peripheral condition of the integral empty and real rubber node;
f. submitting the established model to the finite element analysis software for calculation to obtain stress and strain distribution of all the components and finally the stress and strain contours of the metal coat and metal dabber, and determining the deformation state of the metal coat and metal dabber of the integral empty and real rubber node in specified conditions.

Through the above steps, a more accurate stress and strain contour of the metal coat and the metal dabber can be obtained, which leads to a more accurate calculation result in step (2). The stress transition zone can be more accurately determined, which provides a more accurate scientific base for providing the reinforcement structure lug.

A nodal method is used in the surface connection in step c is to perform common nodal treatment for all the component surfaces. The material and attribute definition in step d is determined by the real loading condition, namely, when the real loading is relatively small, the deformation of the integral empty and real rubber node is relatively small, the metal coat and the metal dabber need only to be defined to be elastic attribute and little deformed constitutive model is chosen for the rubber elastic body; when the real loading is relatively large, the deformation of the integral empty and real rubber node is relatively large, the metal coat and the metal dabber need to be defined as plastic attribute and large deformed or non-linear constitutive model is chosen for the rubber elastic body. In step d, if the size of the different directions of the metal coat and the metal dabber differs significantly, incompatible elements should be chosen. In step e, when the integral empty and real direction rubber node is under the force of the radical preload, a free limit should be added in the direction vertical to the radical preloading direction. In this way, a more accurate calculation result in step (2) can be achieved.

When using the 3D software to establish the model, when the installation component of the integral empty and real direction rubber node is required to have rigidity, then the corresponding radial preloading tool for the real rigidity characteristics or the equal deformation need to be set up in the models. Through the addition of the radical preloading tools, a more accurate simulation of the real product environment can be achieved, and the calculation result of step (2) can be more accurate.

The finite element calculation step in step (4) is the same as the finite element calculation step in step (2), with the only difference that the calculation subject has been changed to an integral empty and real rubber node with a reinforcement structure lug.

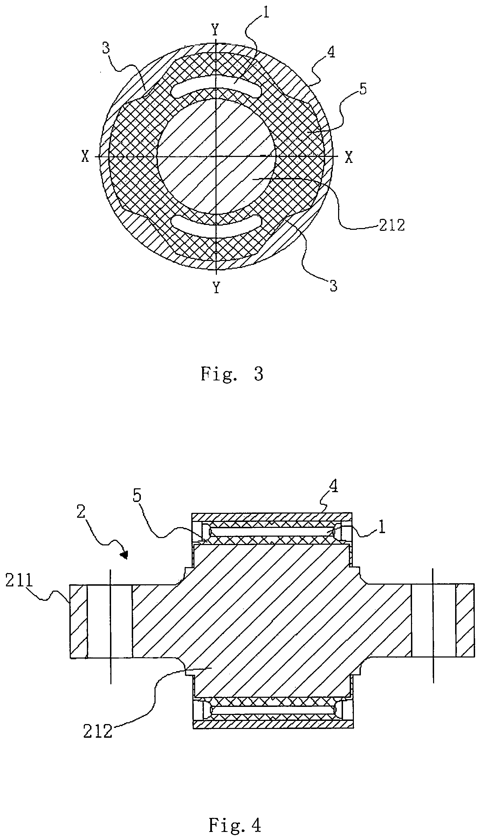

As shown in Fig. 3 to Fig. 5, the current example also discloses an integral empty and real pulling node in the reinforcement method according to the above method, comprising a metal dabber 2 (or metal sleeve), a metal coat 4 and a rubber elastic body 5 with interspaces 1, wherein the metal dabber 2 comprises a metal axis body 211 and a metal dabber flange 212 in the middle of the metal axis body 211, and the rubber elastic body 5 is located between the metal dabber flange 212 of the metal axis body and the metal coat 4, and the rubber elastic body 5, the metal dabber flange 212 of the metal axis body and the metal coat 4 are integrated through sulfuration, characterized in that the inner wall of the metal coat 4 is provided with a reinforcement structure lug 3 which protrudes towards the metal dabber flange 212 of the metal axis body, wherein the reinforcement structure lug 3 is located at the connecting point of the empty and the real directions of the integral empty and real pulling node (namely close to both ends of the interspaces). The reinforcement structure lug 3 can assume a triangle, a trapezoid or an arc form. When the reinforcement structure lug has a form of trapezoid, the area of the reinforcement structure lug can be increase, and therefore, the difference of the degree of deformation of the metal coat in the empty and real directions can be reduced. When the reinforcement structure lug has an arc form, since the arc is smooth, the difference of the degree of deformation of the metal coat in the empty and real directions can be reduced, and in addition, the phenomenon of stress centralization due to angles can be avoided.

Two said interspaces 1 are provided, and their axes about the metal dabber 2 are symmetrically distributed on the rubber elastic body 5. The inner wall of the metal coat 4 is provided with two grooves 6 along the real direction X, wherein the two grooves 6 are symmetric about the metal dabber 2, and the inner wall of the metal coat 4 is also provided with two grooves 7 along the empty direction Y, wherein the two grooves 7 are symmetric about the metal dabber 2, so that the protruding reinforcement lug 3 is formed on the inner all of the metal coat 4 and between the neighbouring real direction groove 6 and empty direction groove 7. When the reinforcement structure lug 3 has a triangle form, said empty direction grove 7 comprises arc shaped empty direction bottom line 711 and direct lines 712 which are located along the two sides of the arc shaped empty direction groove 711. Said real direction groove 6 comprises arc shaped real direction bottom line 611 and direct lines 612 which are located along the two sides of the arc shaped real direction groove. The metal dabber flange 212 is designed to be a prism.

### Embodiment of the current invention:

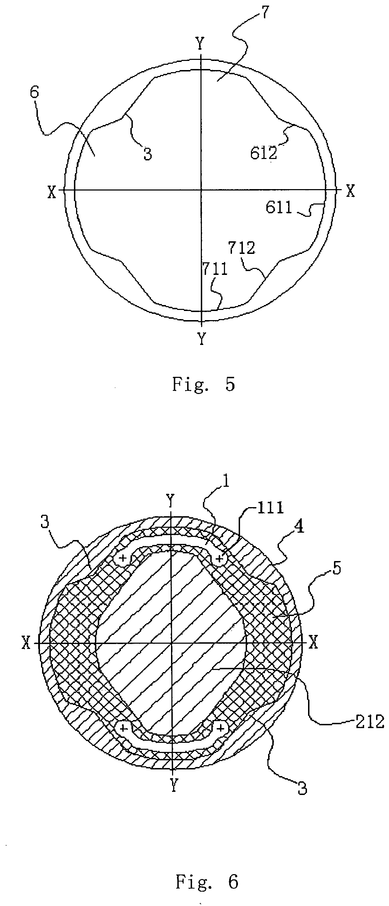

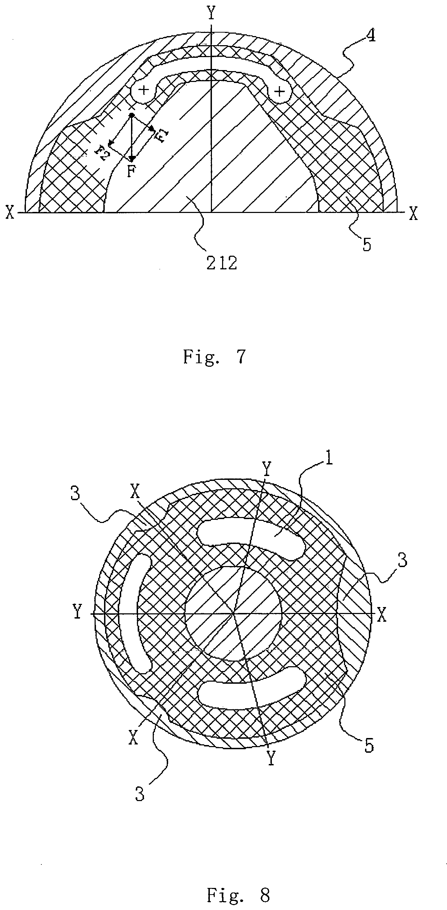

Embodiment 2: As shown in Fig. 6 and 7, in comparison with Embodiment 1, Embodiment differs in that: The metal dabber flange 212 is designed to be a prism with a parallelogram bottom, wherein the four corners are vertical to each other, with one pair opposite corners being located at the empty direction Y and the other pair opposite corners being located at the real direction X, wherein the opposite corner pair along the empty direction Y of the parallelogram prism are round corners, and the other opposite corner pair along the real direction X of the parallelogram prism are also round corners. In this way, the variable rigidity of the integral empty and real direction rubber node of the current invention is achieved as follows: when the rubber node bears load F in the empty direction Y, the original rigidity of the rubber node comes from the shear deformation of the rubber elastic body in the real direction X, which is relatively small in this phase. When the deformation exceeds the interspace distance of the rubber elastic body, the interspaces of the rubber elastic body close and contact each other.

At this moment, the rigidity changes and rigidity turning point appears. With the increase of the deformation, rigidity enters the second phase. In this phase, rigidity comes majorly from the compression deformation of the rubber elastic body in the empty direction Y, and therefore the rigidity in this phase is relatively big. Based on this operational principle, the non-linear rigidity of the current integral empty and real direction rubber node changes abruptly in a relatively small region, and therefore the non-linear characteristic of the rigidity is obvious but lacks smoothness.

In the current example, said metal dabber flange 212 is comprised by four round edge surfaces and four direct line surfaces surrounding between the two parallel bottom surfaces. As shown in Fig. 7, when the rubber node bears loading F, the rubber elastic body is radically compressed by metal dabber flange and metal coat. Under the force of the direct line surface of the metal dabber flange 212 and the direct line 712 of the real direction groove on the inner wall of the metal coat, loading F is decomposed into the compression load F1 which is vertical to the direct line surface of the metal dabber flange and the shear load F2 which parallel to the direct line surface of the metal dabber flange. That is to say, the load of the rubber elastic body of the rubber node is a composite load of the shear and compression load of the rubber elastic body. This composite load provides a rigidity which is between the smallest shear rigidity and the largest compression rigidity, which provides a smooth transition for the non-linear rigidity of the rubber node. The current example realizes the variable rigidity as follows: Assumed that the rubber elastic body has in the empty direction Y one interspace up and one interspace down, wherein the interspace up has a width of t1 whereas the interspace down has a width of t2 (ideally t1=t2). Under the force of the empty direction load, the metal dabber and the metal coat start to perform relative movement in the operational direction. T1 reduces and t2 increases. At this moment, the rigidity of the product comes majorly from the shear rigidity of the rubber elastic body in the real direction (namely, first stage: small rigidity phase). With the increase of the deformation, t1 continues to decrease and t2 continues to increase. Within certain scope, the major rigidity of the product comes from the composite load rigidity of the metal dabber and metal coat of the rubber elastic body. (namely, the second stage: rigidity smooth transition period). With the increase of the deformation, t1 decreases to 0 and t2 continues to increase. The rigidity of the product comes majorly from the addition of the rigidity after the interspace of the rubber elastic body in the empty direction Y closes and the composite load rigidity of the rubber elastic body of the metal dabber of metal coat (namely, the third stage: large rigidity).

As a result, the variable rigidity of the integral empty and real direction structure rubber node in the state of the art has been achieved via two stages, whereas the variable rigidity of the current example has been achieved via three stages. Therefore, the rigidity of the current example has not only obvious non-linear rigidity characteristic, but also non-linear rigidity smooth transition characteristics, which fulfills the requirement of high speed operation as well as comfort ride of the locomotives.

In the current example, the interspace 1 has enlarged part 111 at its both ends. Said enlarged parts 111 have arc form, and can also assume rectangle form. The purpose of the enlarged parts is to accommodate part of the rubber elastic body during deformation, so as to reduce compression of the rubber elastic body, reduces the stress centralization phenomenon and therefore prolong the shelf life of the rubber elastic body.

Example 3: As shown in Fig. 8, in comparison with example 1, the difference lies in: three said interspaces 1 are provided which are circumferentially sequentially distributed on the rubber elastic body 5, wherein two interspaces 1 are distributed symmetrically about the axis of the metal dabber 2. The empty direction Y and the real direction X distribute circumferentially and sequentially in the rubber node. The inner wall of the metal coat along the empty direction Y is provided with three empty direction grooves, which are circumferentially sequentially distributed on the inner wall of the metal coat, so that the reinforcement structure lug 3 is formed on the inner wall of the metal coat between the neighboring empty direction grooves. The reinforcement structure lug 3 and the metal coat4 are integrated. The reinforcement structure lug 3 is arc shaped. It can also have a form of triangle, trapezoid. There are three reinforcement structure lug in total.

### Industrial applicability:

Based on the above, the current invention has the following advantages:
1) The current invention reinforces the metal coat through providing the inner wall of the metal coat in the stress transition zone of the integral empty and real rubber node with a reinforcement structure lug, which significantly reduces the difference of the degree of deformation of the metal coat in the empty and the real directions, and reduces the occurrence of product oval phenomenon, and facilitates the installation of the integral empty and real rubber node, enhances the property and prolong the shelf life of the rubber node as well as avoids the damage of other related components.
2) The current invention localizes the exact position of the reinforcement structure lug in appropriate position of the stress transition zone, which promotes the reinforcement effect. A more accurate stress and strain contour can be obtained through the finite element method of the current invention, which provides a more accurate scientific base for providing the reinforcement structure lug.
3) During the establishment the model using the 3D software, a radical preloading is added in the model, so that a real simulation of the real product environment can be achieved, which facilitates a more accurate calculation.
4) The reinforcement structure lug is designed to be triangle, trapezoid, or oval, which can increases the area of the reinforcement structure lug, in order to further reduce the difference of the degree of deformation of the metal coat in the empty and the real directions, and to avoid stress centralization caused by angle position.
5) The further improvement of the flange of the metal dabber enables the change of the rigidity of the integral empty and real rubber node to be smoothly realized in three stages. As a result, the integral empty and real rubber node of the current invention has not only the obvious non-linear rigidity characteristics, but also the smooth transition characteristics of the non-linear rigidity. This fulfills the requirement of locomotives to have a higher speed but more comfort at the same time.

## Claims

1. A reinforcement method for an integral empty and real direction rubber node, **characterized in that** the reinforcement method is carried out through providing the inner wall of the metal coat (4) in the stress transition zone of the integral empty and real rubber node with a reinforcement structure lug (3) in order to reinforce the metal coat, wherein the exact position of the reinforcement structure lug (3) in the stress transition zone is determined by the distribution of the rigidity, applied force and stress of the integral empty and real rubber node after it is radically compressed, comprising the following steps:
(1) determination of the concrete structure of the integral empty and real rubber node according to the design of the rigidity of the integral empty and real rubber node;
(2) calculation of the distribution of the applied force and the stress after radical compression of the integral empty and real rubber node in step (1) according to finite element method;
(3) determination of the position of the stress transition zone according to the result in step (2), and positioning of the reinforcement structure lug (3) onto the inner wall of the metal coat (4) in the stress transition zone to obtain the integral empty and real rubber node with a reinforcement structure lug (3);
(4) calculation of the distribution of the rigidity, applied force after compression and stress of the integral empty and real rubber node with a reinforcement structure through finite element method;
(5) examining whether the distribution of the rigidity, applied force after compression and stress calculated in step (4) fulfills requirement; if yes, then the entire reinforcement procedure is completed; if there is one item being not in compliance with the requirement, adjusting the position of the reinforcement structure lug (3) on the inner wall of the metal coat (4) in the stress transition zone peripherally, and returning to step (4) until completing the entire reinforcement procedure.

2. The reinforcement method according to claim 1 , **characterized in that** the finite element calculation method is to establish a model through 3D software, and to determine the material nature of different components of the integral empty and real rubber node and then calculate to obtain the stress and strain contours of the metal coat (4) as well as the metal dabber (2), and to determine the deformation state of the metal coat (4) as well as the metal dabber (2) of the integral empty and real rubber node under specified condition, comprising the following steps:
a. using software to establish a geometric feature model of the integral empty and real rubber node and determining geometric characteristics of the different components of the integral empty and real rubber node in the software;
b. converting the geometric feature model of the integral empty and real rubber node into a format which is supported by meshing softwares, and simplifying the details which do not influence the analysis, and finally meshing to all of the components and establishing an integral empty and real rubber node meshing model;
c. performing relationship definition to the corresponding surfaces of all the components of the integral empty and real rubber node , and performing surface connection of all the components according to the relationship definition;
d. performing material and attribute definition of all the components of the integral empty and real rubber node;
e. exerting corresponding peripheral condition and loading condition in the meshing model of the integral empty and real rubber node according to the real loading and peripheral condition of the integral empty and real rubber node;
f. submiting the established model to the finite element analysis software for calculation to obtain stress and strain distribution of all the components and finally the stress and strain contours of the metal coat (4) and metal dabber (2), and determining the deformation state of the metal coat (4) and metal dabber (2) of the integral empty and real rubber node in specified conditions.

3. The reinforcement method according to claim 2 , **characterized in that** a nodal method is used in the surface connection in step c is to perform common nodal treatment for all the component surfaces.

4. The reinforcement method according to claim 2 , **characterized in that** the material and attribute definition in step d is determined by the real loading condition, namely, when the real loading is relatively small, the deformation of the integral empty and real rubber node is relatively small, the metal coat (4) and the metal dabber (2) need only to be defined to be elastic attribute and little deformed constitutive model is chosen for the rubber elastic body (5); when the real loading is relatively large, the deformation of the integral empty and real rubber node is relatively large, the metal coat (4) and the metal dabber (2) need to be defined as plastic attribute and large deformed or non-linear constitutive model is chosen for the rubber elastic body (5).

## Patentansprüche

1. Verstärkungsverfahren für einen einstückigen leeren und echten Richtungsgummiknoten, **dadurch gekennzeichnet, dass** das Verstärkungsverfahren durch Bereitstellen der inneren Wand des Metallüberzugs (4) in der Spannungsübergangszone des einstückigen leeren und echten Gummiknotens mit einem Verstärkungsstrukturansatz (3), um den Metallüberzug zu verstärken, ausgeführt wird, wobei die exakte Position des Verstärkungsstrukturansatzes (3) in der Spannungsübergangszone durch die Verteilung der Steifigkeit, aufgebrachten Kraft und Spannung des einstückigen leeren und echten Gummiknotens bestimmt wird, nachdem er radikal komprimiert wurde, umfassend die folgenden Schritte:
(1) Bestimmung der konkreten Struktur des einstückigen leeren und echten Gummiknotens gemäß dem Entwurf der Steifigkeit des einstückigen leeren und echten Gummiknotens,
(2) Berechnung der Verteilung der aufgebrachten Kraft und der Spannung nach einer radikalen Komprimierung des einstückigen leeren und echten Gummiknotens in Schritt (1) gemäß Finite-Element-Methode,
(3) Bestimmung der Position der Spannungsübergangszone gemäß dem Ergebnis in Schritt (2) und Positionieren des Verstärkungsstrukturansatzes (3) auf der inneren Wand des Metallüberzugs (4) in der Spannungsübergangszone, um den einstückigen leeren und echten Gummiknoten mit einem Verstärkungsstrukturansatz (3) zu erhalten,
(4) Berechnung der Verteilung der Steifigkeit, aufgebrachten Kraft nach einer Komprimierung und Spannung des einstückigen leeren und echten Gummiknotens mit einer Verstärkungsstruktur durch Finite-Element-Methode,
(5) Untersuchen, ob die Verteilung der Steifigkeit, aufgebrachten Kraft nach einer Komprimierung und Spannung, die in Schritt (4) berechnet wird, eine Anforderung erfüllt, wenn ja, dann ist die gesamte Verstärkungsprozedur abgeschlossen, wenn es einen Gegenstand gibt, der mit der Anforderung nicht in Übereinstimmung ist, peripheres Einstellen der Position des Verstärkungsstrukturansatzes (3) auf der inneren Wand des Metallüberzugs (4) in der Spannungsübergangszone und Zurückkehren zu Schritt (4), bis die gesamte Verstärkungsprozedur abgeschlossen ist.

2. Verstärkungsverfahren nach Anspruch 1, **dadurch gekennzeichnet, dass** die Finite-Element-Berechnungsmethode zum Erstellen eines Modells durch 3D-Software und zum Bestimmen der Materialbeschaffenheit von unterschiedlichen Komponenten des einstückigen leeren und echten Gummiknotens und dann Berechnen, um die Spannungs- und Dehnungskonturen des Metallüberzugs (4) sowie des Metallkernhaltestifts (2) zu erhalten, und zum Bestimmen des Verformungszustandes des Metallüberzugs (4) sowie des Metallkernhaltestifts (2) des einstückigen leeren und echten Gummiknotens unter spezifizierter Bedingung ausgelegt ist, umfassend die folgenden Schritte:
a. Verwenden von Software, um ein geometrisches Merkmalmodell des einstückigen leeren und echten Gummiknotens zu erstellen, und Bestimmen von geometrischen Eigenschaften der unterschiedlichen Komponenten des einstückigen leeren und echten Gummiknotens in der Software,
b. Konvertieren des geometrischen Merkmalmodells des einstückigen leeren und echten Gummiknotens in ein Format, das durch Vernetzungssoftware unterstützt wird, und Vereinfachen der Einzelheiten, die die Analyse nicht beeinflussen, und schließlich Vernetzen aller Komponenten und Erstellen eines Netzmodells für einen einstückigen leeren und echten Gummiknoten,
c. Durchführen einer Beziehungsdefinition zu den entsprechenden Flächen aller Komponenten des einstückigen leeren und echten Gummiknotens und Durchführen einer Flächenverbindung aller Komponenten gemäß der Beziehungsdefinition,
d. Durchführen einer Material- und Attributdefinition aller Komponenten des einstückigen leeren und echten Gummiknotens,
e. Ausüben einer entsprechenden peripheren Bedingung und Lastbedingung in dem Netzmodell des einstückigen leeren und echten Gummiknotens gemäß der echten Last- und peripheren Bedingung des einstückigen leeren und echten Gummiknotens,
f. Vorlegen des erstellten Modells der Finite-Element-Analysesoftware zur Berechnung, um eine Spannungs- und Dehnungsverteilung aller Komponenten und schließlich der Spannungs- und Dehnungskonturen des Metallüberzugs (4) und Metallkernhaltestifts (2) zu erhalten, und Bestimmen des Verformungszustandes des Metallüberzugs (4) und Metallkernhaltestifts (2) des einstückigen leeren und echten Gummiknotens in spezifizierten Bedingungen.

3. Verstärkungsverfahren nach Anspruch 2, **dadurch gekennzeichnet, dass** ein Knotenverfahren, das in der Flächenverbindung in Schritt c verwendet wird, zum Durchführen einer gemeinsamen Knotenbehandlung für alle Komponentenflächen ausgelegt ist.

4. Verstärkungsverfahren nach Anspruch 2, **dadurch gekennzeichnet, dass** die Material- und Attributdefinition in Schritt d durch die echte Lastbedingung bestimmt wird, nämlich wenn die echte Last relativ klein ist, die Verformung des einstückigen leeren und echten Gummiknotens relativ klein ist, der Metallüberzug (4) und der Metallkernhaltestift (2) nur definiert werden müssen, um ein elastisches Attribut zu sein, und ein kleines verformtes konstitutives Modell für den elastischen Gummikörper (5) ausgewählt wird, wenn die echte Last relativ groß ist, die Verformung des einstückigen leeren und echten Gummiknotens relativ groß ist, der Metallüberzug (4) und der Metallkernhaltestift (2) als plastisches Attribut definiert werden müssen und ein großes verformtes oder nicht lineares konstitutives Modell für den elastischen Gummikörper (5) ausgewählt wird.

## Revendications

1. Procédé de renforcement pour noeud de direction en caoutchouc vide intégral et réel, **caractérisé en ce que** ce procédé de renforcement est réalisé en pourvoyant la paroi intérieure du revêtement métallique (4) dans la zone de transition de contrainte du noeud de direction en caoutchouc vide intégral et réel d'une patte à structure de renforcement (3) afin de renforcer le revêtement métallique, la position exacte de la patte à structure de renforcement (3) dans la zone de transition de contrainte étant déterminée par la répartition de la rigidité, de la force appliquée et de la contrainte du noeud de direction en caoutchouc vide intégral et réel une fois qu'il est radicalement comprimé, comprenant les étapes suivantes :
(1) détermination de la structure concrète du noeud de direction en caoutchouc vide intégral et réel en fonction de la conception du noeud de direction en caoutchouc vide intégral et réel ;
(2) calcul de la répartition de la force appliquée et de la contrainte après compression radicale du noeud de direction en caoutchouc vide intégral et réel dans l'étape (1) en fonction d'un procédé à élément fini ;
(3) détermination de la position de la zone de transition de contrainte en fonction du résultat de l'étape (2), et positionnement de la patte de structure de renforcement (3) sur la paroi intérieure du revêtement métallique (4) dans la zone de transition de contrainte pour obtenir le noeud de direction en caoutchouc vide intégral et réel avec une patte à structure de renforcement (3) ;
(4) calcul de la répartition de la rigidité, de la force appliquée après compression et contrainte du noeud de direction en caoutchouc vide intégral et réel avec une structure de renforcement par procédé d'élément fini ;
(5) analyse pour déterminer si la distribution de la rigidité, de la force appliquée après compression et de la contrainte calculée dans l'étape (4) remplit les exigences : si oui, toute la procédure de renforcement est réalisée ; s'il y a un article qui n'est pas en conformité avec les exigences, ajustement de la position de la patte à structure de renfort (3) sur la paroi intérieure du revêtement métallique (4) dans la zone de transmission de contrainte en périphérie, et retour à l'étape (4) jusqu'à réalisation de toute la procédure de renforcement.

2. Procédé de renforcement selon la revendication 1, **caractérisé en ce que** le procédé de calcul d'élément fini consiste à établir un modèle par un logiciel 3D, et à déterminer la nature du matériau de différents composants du noeud de direction en caoutchouc vide intégral et réel puis à calculer pour obtenir les contours de contrainte et de tension du revêtement métallique (4) et du tampon métallique (2), et à déterminer l'état de déformation du revêtement métallique (4) et du tampon métallique (2) du noeud de direction en caoutchouc vide intégral et réel sous une condition spécifiée, comprenant les étapes suivantes :
a. utilisation d'un logiciel pour établir un modèle de configuration géométrique du noeud de direction en caoutchouc vide intégral et réel et déterminer les caractéristiques géométriques des différents composants du noeud de direction en caoutchouc vide intégral et réel dans le logiciel ;
b. conversion du modèle de configuration géométrique du noeud de direction en caoutchouc vide intégral et réel en un format qui est compatible avec des logiciels d'engrènement, et simplification des détails qui n'influent pas sur l'analyse, et finalement engrènement avec tous les composants et établissement d'un modèle d'engrènement du noeud en caoutchouc vide et réel intégral ;
c. réalisation d'une définition de relation avec les surfaces correspondantes de tous les composants d'une en caoutchouc vide et réel intégral, et réalisation d'une connexion de surface de tous les composants du noeud en caoutchouc vide et réel intégral en fonction de la définition de relation ;
d. réalisation d'une définition de matériaux et d'attributs de tous les composants du noeud en caoutchouc vide et réel intégral ;
e. application d'une condition périphérique et d'une condition de chargement correspondante dans le modèle d'engrènement du noeud en caoutchouc vide et réel intégral en fonction de la condition réelle de chargement et périphérique du noeud en caoutchouc vide et réel intégral ;
f. soumission du modèle établi au logiciel d'élément fini destiné au calcul pour obtenir une répartition de contrainte et de tension de tous les composants et finalement les contours de contrainte et de tension du revêtement métallique (4) et du tampon métallique (2), et détermination de l'état de déformation du revêtement métallique (4) et du tampon métallique (2) du noeud en caoutchouc vide et réel intégral dans des conditions spécifiées.

3. Procédé de renforcement selon la revendication 2, **caractérisé en ce qu'**un procédé nodal est utilisé dans la connexion de surface dans l'étape c pour réaliser un traitement nodal commun pour tous les composants de surface.

4. Procédé de renforcement selon la revendication 2, **caractérisé en ce que** la définition de matériaux et d'attributs dans l'étape d est déterminée par la condition de chargement réelle, à savoir que, lorsque la charge réelle est relativement réduite, la déformation du noeud en caoutchouc vide et réel intégral est relativement réduite, le revêtement métallique (4) et le tampon métallique (2) ont seulement besoin d'être définis sous forme d'un attribut élastique et un modèle constitutif peu déformé et choisi pour le corps élastique (5) ; lorsque la charge réelle est relativement importante, la déformation du noeud en caoutchouc vide et réel intégral est relativement importante, le revêtement métallique (4) et le tampon métallique (2) ont besoin d'être définis sous forme d'un attribut plastique et un modèle constitutif de grande taille déformé ou non linéaire est choisi pour le corps élastique en caoutchouc (5).
